# EUROPEAN PATENT APPLICATION

(11) **EP 4 701 043 A1**
(43) Date of publication of application: **25.02.2026**
(21) Application number: 24811345.8
(22) Date of filing: 16.05.2024
(51) Int. Cl.: H02J 50/10, H02J 50/90, H02J 50/60, G01R 19/165, H02J 50/12

(54) **ELECTRONIC DEVICE FOR WIRELESS POWER TRANSMISSION AND OPERATING METHOD THEREOF**

(30) Priority: 22.05.2023 KR 20230065448; 21.07.2023 KR 20230095575
(71) Applicant: Samsung Electronics Co., Ltd., Suwon-si, Gyeonggi-do 16677 (KR)
(72) Inventor: HA, Mincheol, Suwon-si Gyeonggi-do 16677 (KR); KIM, Dongzo, Suwon-si Gyeonggi-do 16677 (KR); CHUNG, Hyungkoo, Suwon-si Gyeonggi-do 16677 (KR)
(74) Representative: Nederlandsch Octrooibureau
(86) International application number: PCT/KR2024/006681
(87) International publication number: WO 2024/242406

(57) **Abstract**

An electronic device for wireless power transmission according to an embodiment may comprise: a coil; an inverter configured to provide power to the coil; a power provision circuit configured to provide a voltage for driving the inverter; and a control circuit. The control circuit according to an embodiment may be configured to output a first ping signal through the coil by applying predefined first voltage to the inverter. The control circuit according to an embodiment may be configured to monitor a first current applied to the inverter while outputting the first ping signal. The control circuit according to an embodiment may be configured to check whether the first current matches a predefined current. The control circuit according to an embodiment may be configured to adjust the magnitude of the first voltage applied to the inverter such that the first current matches the predefined current on the basis of the first current not matching the predefined current. The control circuit according to an embodiment may be configured to determine a voltage value applied to the inverter in a ping page step on the basis of adjustment of the magnitude of the first voltage.

## Description

### [Technical Field]

Various embodiments of the disclosure relate to an electronic device wirelessly transmitting power and a method of operating the same.

### [Background Art]

Wireless charging technology adopts wireless power transmission/reception. For example, wireless charging may automatically charge the battery of a mobile phone by simply placing the mobile phone on a wireless power transmission device (e.g., a charging pad) without connection via a separate charging connector. Wireless communication technology eliminates the need for a connector for supplying power to electronics, thus providing enhanced waterproofing, and also requires no wired charger to thus provide better portability.

As wireless charging technology develops, there is ongoing research for methods for charging other various electronic devices (e.g., wireless power reception device) by supplying power to the other electronic devices by an electronic device (e.g., wireless power transmission device). Wireless charging comes in a few different types, such as of electromagnetic induction, resonance, and radio frequency (RF)/microwave radiation that converts electrical energy into microwaves and transfers the microwaves.

For example, wireless charging techniques using electromagnetic induction or resonance are being widely adopted for electronic devices, such as smartphones. If a power transmitting unit (PTU) (e.g., a wireless power transmission device) and a power receiving unit (PRU) (e.g., a smartphone or a wearable electronic device) contact each other or approach within a predetermined distance, a battery of the wireless power reception device may be charged by an electromagnetic induction or electromagnetic resonance method between a transmission coil (or transmission resonator) of the wireless power transmitter and a receiving coil (or receiving resonator) of the wireless power reception device.

### [Detailed Description of the Invention]

### [Technical Solution]

According to an embodiment, an electronic device wirelessly transmitting power may include a coil, an inverter configured to provide power to the coil, a power providing circuit configured to provide a voltage for driving the inverter, and a control circuit. According to an embodiment, the control circuit may be configured to apply a designated first voltage to the inverter to output a first ping signal through the coil. According to an embodiment, the control circuit may be configured to monitor a first current applied to the inverter while outputting the first ping signal. According to an embodiment, the control circuit may be configured to identify whether the first current matches a predesignated current. According to an embodiment, the control circuit may be configured to adjust the magnitude of the first voltage applied to the inverter so that the first current matches the predesignated current, based on the first current not matching the predesignated current. According to an embodiment, the control circuit may be configured to determine a voltage value to be applied to the inverter in a ping phase stage based on the adjustment of the magnitude of the first voltage.

According to an embodiment, a method of operating an electronic device wirelessly transmitting power may include applying a designated first voltage to an inverter included in the electronic device to output a first ping signal through a coil included in the electronic device. According to an embodiment, the method of operating the electronic device may include monitoring a first current applied to the inverter while outputting the first ping signal. According to an embodiment, the method of operating the electronic device may include determining whether the first current matches a predesignated current. According to an embodiment, the method of operating the electronic device may include adjusting the magnitude of the first voltage applied to the inverter so that the first current matches the predesignated current, based on the first current not matching the predesignated current. According to an embodiment, the method of operating the electronic device may include determining a voltage value to be applied to the inverter in a ping phase stage based on the adjustment of the magnitude of the first voltage.

According to an embodiment, a non-transitory recording medium may store instructions executable to perform operations including applying a designated first voltage to an inverter included in an electronic device wirelessly transmitting power to output a first ping signal through a coil included in the electronic device, monitoring a first current applied to the inverter while outputting the first ping signal, determining whether the first current matches a predesignated current, adjusting the magnitude of the first voltage applied to the inverter so that the first current matches the predesignated current based on the first current not matching the predesignated current, and determining a voltage value to be applied to the inverter in a ping phase stage based on the adjustment of the magnitude of the first voltage.

### [Brief Description of Drawings]

FIG. 1 is a block diagram illustrating an electronic device wirelessly transmitting power and a wireless power reception device according to an embodiment.
FIG. 2 is a block diagram illustrating a wireless charging system according to an embodiments.
FIG. 3 is a block diagram illustrating an electronic device according to an embodiment.
FIG. 4 is a graph illustrating a change in resonance frequency according to component tolerance included in an electronic device according to an embodiment.
FIG. 5 is a flowchart illustrating a method by which an electronic device determines a voltage applied to an inverter to output a ping signal according to an embodiment.
FIG. 6 is a flowchart illustrating a method by which an electronic device determines a voltage applied to an inverter to output a ping signal according to an embodiment.
FIG. 7 is a flowchart illustrating a method by which an electronic device determines a voltage applied to an inverter to output a ping signal in a process mode according to an embodiment.
FIG. 8 is a flowchart illustrating a method by which an electronic device adjusts setting values in a ping phase stage according to an embodiment.
FIGS. 9A and 9B are views illustrating setting values adjusted by an electronic device according to an embodiment.
FIG. 10 is a block diagram illustrating an electronic device in a network environment according to various embodiments.

### [Mode for Carrying out the Invention]

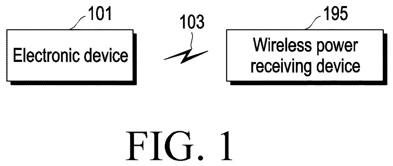

FIG. 1 is a block diagram illustrating an electronic device wirelessly transmitting power and a wireless power reception device according to various embodiments.

Referring to FIG. 1, according to various embodiments, an electronic device 101 may wirelessly transmit power 103 to a wireless power reception device 195. For example, the electronic device 101 may transmit the power 103 by an induction scheme. In case of adopting the induction scheme, the electronic device 101 may include, e.g., a power source (or power supply source), a direct current (DC)-alternating current (AC) converting circuit, an amplifying circuit, an impedance matching circuit, at least one capacitor, at least one coil, or a communication modulation/demodulation circuit. The at least one capacitor, together with the at least one coil, may be included in a resonance circuit. The electronic device 101 may be implemented in a scheme defined in the wireless power consortium (WPC) standards (or Qi standards). As another example, the electronic device 101 may transmit the power 103 by a resonance scheme. In case of adopting the resonance scheme, the electronic device 101 may include, e.g., a power source (or power supply source), a DC-AC converting circuit, an amplifying circuit, an impedance matching circuit, at least one capacitor, at least one coil, or an out-of-band communication circuit (e.g., a Bluetooth low energy (BLE) communication circuit). The at least one capacitor and the at least one coil may be included in a resonance circuit. The electronic device 101 may be implemented in a manner defined in the alliance for wireless power (A4WP) standards (or AirFuel Alliance (AFA) standards). The electronic device 101 may include a coil that is capable of producing a magnetic field when letting an electric current flow thereacross by a resonance or induction scheme. The process of the electronic device 101 producing an induced magnetic field may be represented as the electronic device 101 wirelessly transmitting the power 103. Further, the wireless power reception device 195 may include a coil that produces an induced electromotive force by the magnetic field generated around and varying in magnitude over time. The process of producing an induced electromotive force through the coil may be represented as the 'wireless power reception device 195 wirelessly receives the power 103.' For example, the electronic device 101 may be implemented in the manner defined in wireless power transmission-related standards, e.g., the AirFuel inductive (e.g., power matters alliance (PMA)) or AirFuel resonant (e.g., Rezence) standards, or a Qi standard.

The electronic device 101 according to various embodiments may communicate with the wireless power receiving device 195. For example, the electronic device 101 may communicate with the wireless power receiving device 195 according to an in-band scheme. The electronic device 101 may modulate data to be transmitted according to, e.g., a frequency shift keying (FSK) modulation scheme, and the wireless power reception device 195 may perform modulation according to an amplitude shift keying (ASK) modulation scheme. The electronic device 101 and/or the wireless power reception device 195 may determine the data transmitted from the counterpart device based on the frequency and/or amplitude of the current, voltage, or power of the coil. The operation of performing modulation based on the ASK modulation scheme and/or the FSK modulation scheme may be understood as an operation for transmitting data according to the in-band communication scheme. The operation of determining the data transmitted from the counterpart device by performing demodulation based on the frequency and/or amplitude of the current, voltage, or power of the coil may be understood as an operation for receiving data according to the in-band communication scheme. For example, the electronic device 101 may communicate with the wireless power receiving device 195 according to an out-of-band scheme. The electronic device 101 or the wireless power reception device 195 may transmit and/or receive data using a communication circuit (e.g., a BLE communication module) provided separately from the coil or patch antennas.

In various embodiments of the disclosure, when the electronic device 101 or the wireless power reception device 195 performs a particular operation, this may mean that various hardware devices, e.g., a control circuit, such as a processor (e.g., a transmission IC or micro controller unit (MCU)), or coil included in the electronic device 101 or the wireless power reception device 195 performs the particular operation. When the electronic device 101 or the wireless power reception device 195 performs a particular operation, this may also mean that the processor controls another hardware device to perform the particular operation. When the electronic device 101 or the wireless power reception device 195 performs a particular operation, this may mean that the processor or another hardware device triggers the particular operation as at least one instruction for performing the particular operation, which is stored in a storage circuit (e.g., a memory) of the electronic device 101 or the wireless power reception device 195, is executed.

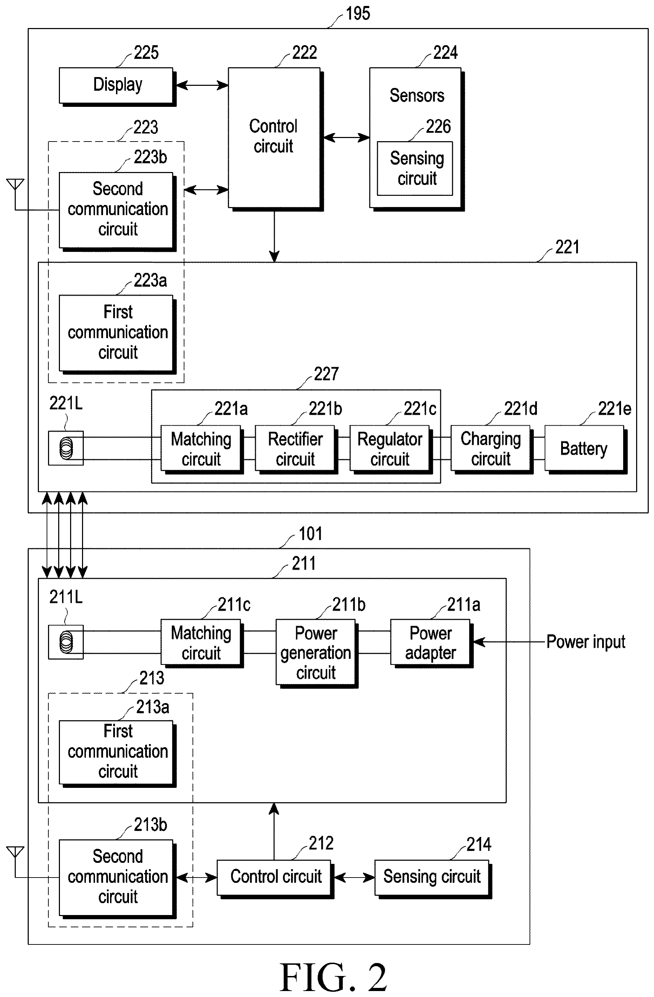

FIG. 2 is a block diagram illustrating a wireless charging system according to various embodiments;
Referring to FIG. 2, according to various embodiments, a wireless charging system may include an electronic device 101 and a wireless power reception device 195. For example, if the wireless powered reception device 195 is mounted on the electronic device 101, the electronic device 101 may wirelessly supply power to the wireless powered reception device 195.

According to various embodiments, the electronic device 101 may include a power transmission circuit 211, a control circuit 212, a communication circuit 213, or a sensing circuit 214.

According to various embodiments, the power transmission circuit 211 may include a power adapter 211a that receives power from the outside and appropriately converts the voltage of the input power, a power generation circuit 211b that generates power, or a matching circuit 211c that enhances transmission efficiency between the coil 211L and the coil 221L.

According to various embodiments, the control circuit 212 may perform the overall control of the electronic device 101. The control circuit 212 may generate various messages (e.g., instructions) necessary for wireless power transmission and may transfer the generated messages to the communication circuit 213. In an embodiment, the control circuit 212 may calculate power (or an amount of power) to be transmitted to the wireless power reception device 195 based on the information received from the communication circuit 213. In an embodiment, the control circuit 212 may control the power transmission circuit 211 so that power generated by the coil (or radiator) 211L is transmitted to the wireless power reception device 195.

According to various embodiments, the communication circuit 213 may include at least one of a first communication circuit 213a or a second communication circuit 213b. For example, the first communication circuit 213a may communicate with the first communication circuit 223a of the wireless power reception device 195 based on an in-band (IB) communication scheme using a frequency that is identical or adjacent to the frequency used for power transfer in the coil 211L.

The first communication circuit 213a may communicate with the first communication circuit 223a of the wireless power reception device 195 using the transmission coil 211L. Data (or a communication signal) generated by the first communication circuit 213a may be transmitted using the coil 211L. The first communication circuit 213a may transfer data to the wireless power reception device 195 using a frequency shift keying (FSK) modulation scheme. According to various embodiments, the first communication circuit 213a may communicate with the first communication circuit 223a of the wireless power reception device 195 by changing the frequency of the power signal transferred through the coil 211L. Alternatively, the first communication circuit 213a may communicate with the first communication circuit 223a of the wireless power reception device 195 by allowing data to be included in the power signal generated by the power generation circuit 211b. For example, the first communication circuit 213a may perform modulation by increasing or decreasing the frequency of the power transmission signal. The wireless power reception device 195 may identify data from the electronic device 101 by performing demodulation based on the frequency of the signal measured by the coil 221L.

For example, the second communication circuit 213b may communicate with the second communication circuit 223b of the wireless power reception device 195 based on an out-of-band (OOB) communication scheme using a frequency different from the frequency used for power transfer in the coil 211L. For example, the second communication circuit 213b may obtain information related to the charging status (e.g., the voltage value behind the rectifier, the rectified voltage value (e.g., Vrect) information, current information (e.g., lout) flowing through the coil 221L or the rectifying circuit 221b, various packets, authentication information, and/or messages) from the second communication circuit 223b using any one of various short-range communication schemes such as Bluetooth, Bluetooth low energy (BLE), Wi-Fi, or near field communication (NFC).

According to various embodiments, the sensing circuit 214 may include at least one sensor, and may detect at least one state of the electronic device 101 using the at least one sensor.

According to various embodiments, the sensing circuit 214 may include at least one of a temperature sensor, a motion sensor, a magnetic field sensor (hall sensor), or a current (or voltage) sensor, may detect the temperature state of the electronic device 101 using the temperature sensor, may detect the motion state of the electronic device 101 using the motion sensor, may detect whether the electronic device 101 is coupled to the wireless power reception device 195 using the magnetic field sensor, and may detect the state, e.g., the current level, the voltage level, and/or the power level, of the output signal of the electronic device 101 using the current (or voltage) sensor.

According to an embodiment, the current (or voltage) sensor may measure the signal in the power transmission circuit 211. The current (or voltage) sensor may measure a signal in at least a partial area of the matching circuit 211c or the power generation circuit 211b. For example, the current (or voltage) sensor may include a circuit for measuring a signal at a front end of the coil 211L.

According to various embodiments, the sensing circuit 214 may include a circuit for foreign object detection (FOD).

According to various embodiments, the sensing circuit 214 may identify a change in capacitance due to a foreign object. For example, the sensing circuit 214 may identify a change in capacitance as a foreign object approaches or contacts (or is mounted on) the electronic device 101. Further, the sensing circuit 214 may provide a sensing value (or capacitance change amount) indicating a change in capacitance to the control circuit 212. For example, the sensing circuit 214 may include a coil and a sensor IC for sensing a change in capacitance.

According to various embodiments, the wireless power reception device 195 may include a power reception circuit 221, a control circuit 222, a communication circuit 223, sensors 224, or a display 225. The sensors 224 may include a sensing circuit 226.

According to various embodiments, the power reception circuit 221 may include a coil 221L that wirelessly receives power from the electronic device 101, an Rx IC 227, a charging circuit 221d (e.g., a PMIC, a DCDC converter, a switched capacitor, or a voltage divider), or a battery 221e. In an embodiment, the Rx IC 227 may include a matching circuit 221a connected to the coil 221L, a rectifying circuit 221b for rectifying the received AC power to DC, or an adjusting circuit (e.g., an LDO) 221c for adjusting a charging voltage.

According to various embodiments, the control circuit 222 may perform the overall control of the wireless power reception device 195. The control circuit 222 may generate various messages necessary for wireless power reception and transfer the generated messages to the communication circuit 223.

According to various embodiments, the communication circuit 223 may include at least one of a first communication circuit 223a or a second communication circuit 223b. The first communication circuit 223a may communicate with the electronic device 101 through the coil 221L.

The first communication circuit 223a may communicate with the first communication circuit 213a of the electronic device 101 using the coil 221L. Data (or a communication signal) generated by the first communication circuit 223a may be transmitted using the coil 221L. The first communication circuit 223a may transfer data to the electronic device 101 using an amplitude shift keying (ASK) modulation scheme. For example, the first communication circuit 223a may cause a change in the load of the electronic device 101 according to the modulation scheme. Accordingly, at least one of the voltage, the current, or the magnitude of power measured at the coil 211L may be changed. The first communication circuit 213a of the electronic device 101 may identify data by the wireless power reception device 195 by demodulating the change in magnitude. The second communication circuit 223b may communicate with the electronic device 101 using any one of various short-range communication schemes such as Bluetooth, BLE, Wi-Fi, or NFC.

In various embodiments of the disclosure, packets, information, or data transmitted and received by the electronic device 101 and the wireless power reception device 195 may be transmitted and/or received through at least one of the first communication circuit 223a or the second communication circuit 223b.

According to various embodiments, the sensors 224 may include at least some of a current/voltage sensor, a temperature sensor, an illuminance sensor, or an acceleration sensor.

According to various embodiments, the sensing circuit 226 may detect the electronic device 101 by detecting a search signal or power received from the electronic device 101. The sensing circuit 226 may detect a signal change in the input/output terminal of the coil 221L, the matching circuit 221a, or the rectifying circuit 221b due to the signal of the coil 221L generated by the signal output from the electronic device 101. According to various embodiments, the sensing circuit 226 may be included in the reception circuit 221.

According to various embodiments, the display 225 may display various types of display information necessary for wireless power transmission/reception.

According to various embodiments, an electronic device that wirelessly transmits power according to an electromagnetic induction scheme may detect whether a wireless power reception device is mounted and may periodically transmit a ping signal (or ping energy) to wake up the wireless power reception device. In this case, the wireless power reception device may wake up the RX IC only with the ping signal (or ping energy) provided from the electronic device without power supply through a separate battery. Accordingly, the electronic device may periodically transmit a ping signal (or ping energy) having a preidentified interval to identify a mounting time of a wireless power reception device 195. According to implementation, an electronic device 101 may identify a capacitance change due to approach or mounting of an external object (or the wireless power reception device 195) using a separate conductive pattern disposed in an area where a coil 211L is positioned. The electronic device 101 may transmit a ping signal when approach or mounting of an external object (or wireless power reception device) is identified based on the capacitance change.

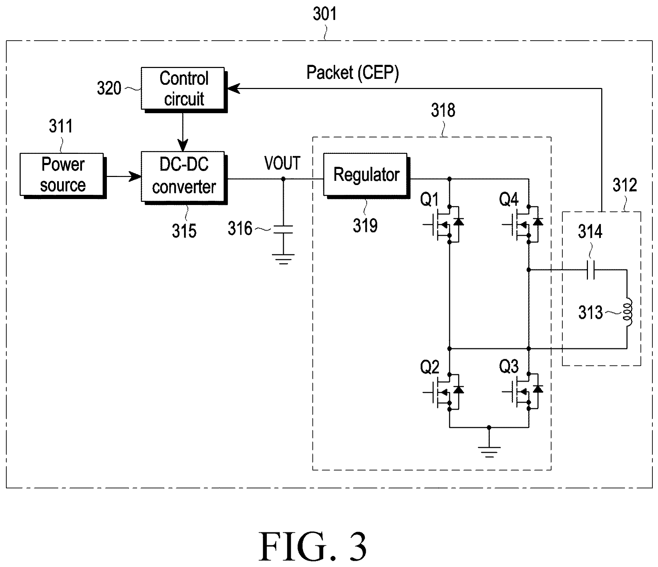

FIG. 3 is a block diagram illustrating an electronic device according to an embodiment;
Referring to FIG. 3, according to an embodiment, an electronic device 301 may include a power source 311, a DC-DC converter 315, a capacitor 316, an inverter 318 including a plurality of switches Q1, Q2, Q3, Q4 and a regulator 319, a transmission circuit 312 including a capacitor 314 and a first coil 313, and a control circuit 320. For example, the electronic device 301 may be implemented to be identical or similar to the electronic device 101 of FIG. 1.

According to an embodiment, power provided by the power source 311 may be provided to the DC-DC converter 315. The power source 311 may include at least one of an interface for connection to an external travel adapter (TA), a battery (not illustrated) of the electronic device 301, a charger (not illustrated), or a power management integrated circuit (PMIC) (not illustrated). The power source 311 may provide, e.g., DC power to the DC-DC converter 315, but there is no limitation on the form of power provided. The DC-DC converter 315 (e.g., power providing circuit) may convert the voltage of the received power and provide it to the inverter 318. The DC-DC converter 315 may change the voltage of the received DC power to provide DC power having a changed voltage (or output voltage VOUT) to the inverter 318. The DC-DC converter 315 may perform, e.g., buck converting and/or boost converting, and may be implemented as, e.g., a 3-level converter, but those skilled in the art will understand that there is no limitation on its type. The voltage output from the DC-DC converter 315 may be stored in the capacitor 316 before being applied to the inverter 318.

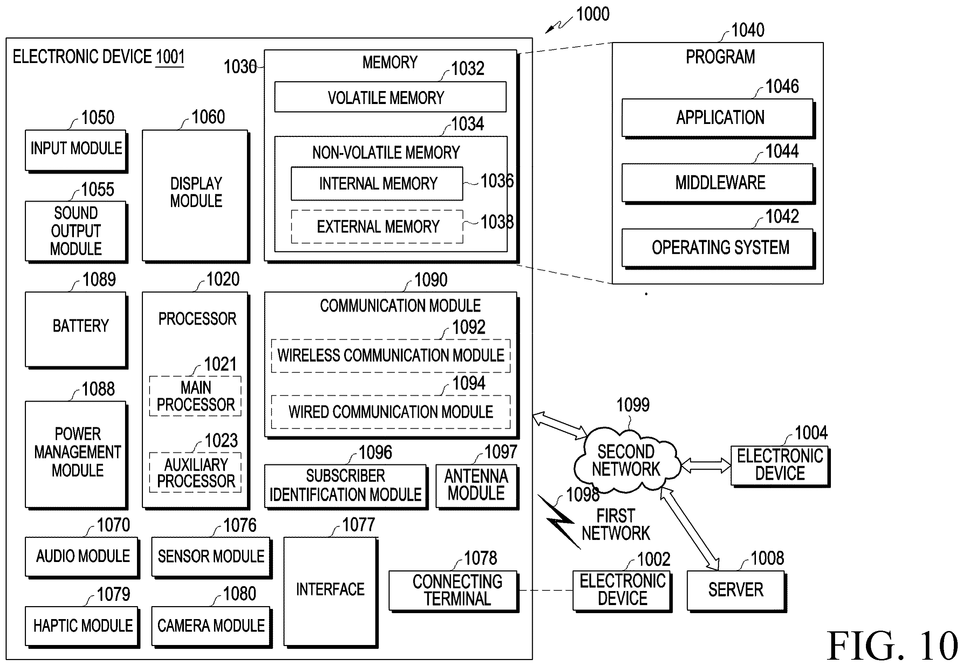

According to an embodiment, the control circuit 320 may control the overall operation of the electronic device 301. For example, the control circuit 320 may be implemented as a PMIC (e.g., the power management module 1088 of FIG. 10), a processor (e.g., the processor 1020 of FIG. 10), or an application processor (e.g., the main processor 1021 of FIG. 10).

According to an embodiment, the control circuit 320 may determine the output voltage VOUT or the magnitude of the output voltage VOUT of the DC-DC converter 315. The control circuit 320 may output a control signal to the DC-DC converter 315 so that the DC-DC converter 315 generates the determined output voltage. The DC-DC converter 315 may convert (e.g., buck convert or boost convert) the voltage of the power provided from the power source 311 according to the control of the control circuit 320.

According to an embodiment, the inverter 318 may output AC power using the output voltage VOUT provided from the DC-DC converter 315. The inverter 318 may further include a regulator 319. The regulator 319 may perform converting (e.g., buck converting and/or boost converting) and/or regulating on the power output from the DC-DC converter 315, and may apply the converted or regulated power to the plurality of switches Q1, Q2, Q3, Q4. For example, the regulator 319 may be implemented as a low dropout (LDO). The plurality of switches Q1, Q2, Q3, Q4 may configure, e.g., a full bridge circuit, but there is no limitation on the number of switches or the type of bridge circuit. For example, when a full bridge circuit is configured, one end of the first coil 313 may be connected to the connection point between the switches Q1, Q2 through the capacitor 314, and the other end of the first coil 313 may be connected to the connection point between the switches Q3, Q4. The plurality of switches Q1, Q2, Q3, Q4 may be controlled to be in an on state or an off state. For example, to generate AC power, the control circuit 320 may control the first switch Q1 and the third switch Q3 to be in an on state while controlling the second switch Q2 and the fourth switch Q4 to be in an off state during a first period, and may control the first switch Q1 and the third switch Q3 to be in an off state while controlling the second switch Q2 and the fourth switch Q4 to be in an on state during a second period, and may repeatedly perform the above-described control operations. The control circuit 320 may provide control signals for controlling the on/off state of the plurality of switches Q1, Q2, Q3, Q4 to the plurality of switches Q1, Q2, Q3, Q4. Here, not only outputting a control signal but also refraining from outputting a control signal may also be referred to as control by the control circuit 320.

According to an embodiment, the control circuit 320 may determine a switching frequency for switching the on/off state of the plurality of switches Q1, Q2, Q3, Q4. For example, the switching frequency may refer to a frequency for alternately changing the switches in an on state among the plurality of switches Q1, Q2, Q3, Q4. The control circuit 320 may generate AC power having a specific frequency through the switching frequency of the plurality of switches Q1, Q2, Q3, Q4. For example, the control circuit 320 controlling the inverter 318 to generate AC power having a first frequency may mean that the control circuit 320 outputs a control signal to control the switches Q1, Q3 to be in an on state for a period corresponding to the first frequency, then outputs a control signal to control the switches Q2, Q4 to be in an on state for a period corresponding to the first frequency, and repeats the above-described output operations.

Meanwhile, the control circuit 320 controlling the inverter 218 to generate AC power having a second frequency may mean that the control circuit 320 outputs a control signal to control the switches Q1, Q3 to be in an on state for a period corresponding to the second frequency, then outputs a control signal to control the switches Q2, Q4 to be in an on state for a period corresponding to the second frequency, and repeats the above-described output operations, and in this case, the period corresponding to the second frequency may be different from the period corresponding to the first frequency.

According to an embodiment, the AC power generated by the inverter 318 may be applied to the first coil 313. The capacitor 314 may form a resonance circuit 212 with the first coil 313. The first coil 313 may form a magnetic field based on the applied AC power. A portion of the magnetic field (or magnetic flux) formed by the first coil 313 may pass through the cross-section of the coil (e.g., 221L of FIG. 2) of the wireless power reception device (e.g., the wireless power reception device 195 of FIG. 1). As the magnetic field passing through the cross-section of the coil 221L of the wireless power reception device 195 changes over time, an induced electromotive force (e.g., current, voltage, or power) may be generated in the coil 221L.

According to an embodiment, the control circuit 320 may identify information provided by the wireless power reception device 195 through the first coil 313. The control circuit 320 may perform, e.g., analog-to-digital converting (ADC) on a signal received through the first coil 313. The control circuit 320 may decode the digital value obtained as a result of the ADC, and may identify information provided by the wireless power reception device 195 according to the decoding result. For example, the electronic device 301 may receive an ASK modulation signal. The electronic device 301 may detect changes in voltage and/or current occurring in the transmission circuit (or resonance circuit) 312 or the inverter 318 due to the ASK modulation signal and decode the corresponding signal. The decoding method may be, e.g., according to the Qi standard, but those skilled in the art will understand that there is no limitation.

According to an embodiment, the control circuit 320 may determine the magnitude of the output voltage (or input voltage of the inverter 318) VOUT of the DC-DC converter 315 in an initialization stage. For example, the control circuit 320 may determine the output voltage VOUT or the magnitude of the output voltage VOUT based on a packet (e.g., control error packet (CEP)) received from the wireless power reception device 195. Thereafter, the control circuit 320 may apply the determined output voltage VOUT to the inverter 318 to wirelessly transmit power to the wireless power reception device 195. For example, the initialization stage may refer to a stage before transmitting power to the wireless power reception device 195 in earnest. For example, the initialization stage may include a ping phase stage.

According to an embodiment, the control circuit 320 may adjust the magnitude of the transmitted power based on a packet (e.g., control error packet (CEP)) received from the wireless power reception device 195 in a power transmission stage. Further, the control circuit 320 may adjust a threshold (or threshold power) for foreign object detection based on a packet (e.g., control error packet (CEP)) received from the wireless power reception device 195 in the power transmission stage.

Meanwhile, the number or type of switches illustrated in FIG. 3 is merely an example, and embodiments of the present invention may not be limited thereto.

According to an embodiment, the control circuit 320 may calibrate a voltage applied to the inverter 318 in a ping phase stage. For example, due to tolerances of components (e.g., the capacitor 314 and/or the inductor 313) included in the electronic device 301, the resonance frequency of the transmission circuit 312 may differ from the intended resonance frequency. In this case, the magnitude of the power (e.g., power of the ping signal) transmitted by the electronic device 301 to the wireless power reception device 195 may differ from the originally intended magnitude of power. Accordingly, the control circuit 320 may calibrate the voltage applied to the inverter 318 in the ping phase stage to adjust the magnitude of the power of the ping signal due to component tolerance. For example, the electronic device 301 may calibrate the voltage applied to the inverter 318 in a state in which the wireless power reception device 195 is not located near the electronic device 301. Alternatively, the electronic device 301 may calibrate the voltage applied to the inverter 318 in a state in which the wireless power reception device 195 is not mounted on the electronic device 301. For example, the electronic device 301 may calibrate the voltage applied to the inverter 318 in an assembly process stage (or assembly process mode).

According to an embodiment, for the calibration, the control circuit 320 may apply a designated first voltage to the inverter 318 to output a first ping signal through the coil 313. The control circuit 320 may monitor a first current applied to the inverter 318 while outputting the first ping signal.

According to an embodiment, the control circuit 320 may identify whether the first current matches a predesignated current. For example, the predesignated current may have a current value set as default. For example, the predesignated current may be automatically determined by the control circuit (e.g., the control circuit 320 of FIG. 3) or may be determined by a user. When it is identified that the first current does not match the predesignated current, the control circuit 320 may adjust the magnitude of the first voltage applied to the inverter so that the first current matches the predesignated current. For example, if it is identified that the first current is greater than the predesignated current, the control circuit 320 may decrease the magnitude of the first voltage applied to the inverter 318 to decrease the magnitude of the first current. Alternatively, if it is identified that the first current is less than the predesignated current, the control circuit 320 may increase the magnitude of the first voltage applied to the inverter 318 to increase the magnitude of the first current. The control circuit 320 may determine and store a voltage value to be applied to the inverter 318 in a ping phase stage based on the adjustment of the magnitude of the first voltage. In this case, the determined voltage value may be a voltage value applied to the inverter 318 when the first current matches the predesignated current.

According to an embodiment, if it is identified that the first current matches the predesignated current, the control circuit 320 may identify and store the first voltage as a voltage value to be applied to the inverter 318 in the ping phase stage.

Through the above-described method, the electronic device 301 may adjust the magnitude of the power (e.g., power of the ping signal) transmitted to the wireless power reception device 195 to the originally intended constant magnitude of power even when there are tolerances in the components (e.g., the capacitor 314 and/or the inductor 313) included in the electronic device 301. Accordingly, the electronic device 301 may increase the detection capability of foreign objects (e.g., metal foreign objects) located between the electronic device 301 and the wireless power reception device 195.

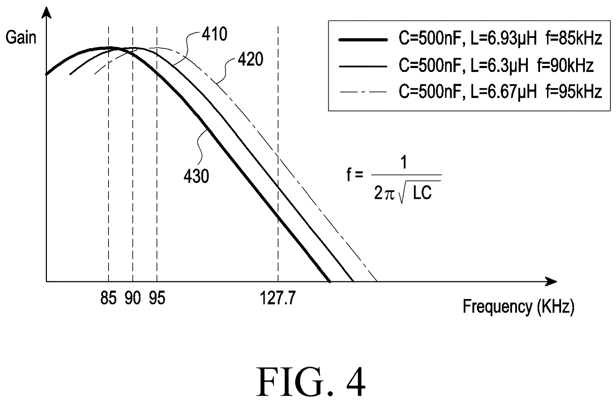

FIG. 4 is a graph illustrating a change in resonance frequency according to component tolerance included in an electronic device according to an embodiment.

Referring to FIG. 4, according to an embodiment, a component (e.g., coil) included in the electronic device 301 may have a tolerance in the value represented by the component. For example, the tolerance range may be -10% to +10% based on the value represented by the component.

According to an embodiment, a first graph 410 may represent a power value of a ping signal output by the electronic device 301 according to frequency change when there is no tolerance in the inductance of the coil 313. For example, in the first graph 410, the inductance may be 6.3µH, the capacitance may be 500nF, and the resonance frequency may be 90kHz.

According to an embodiment, a second graph 420 may represent a power value of a ping signal output by the electronic device 301 according to frequency change when there is a -10% tolerance in the inductance of the coil 313. For example, in the second graph 420, the inductance may be 6.67µH, the capacitance may be 500nF, and the resonance frequency may be 95kHz.

According to an embodiment, a third graph 430 may represent a power value of a ping signal output by the electronic device 301 according to frequency change when there is a +10% tolerance in the inductance of the coil 313. For example, in the third graph 430, the inductance may be 6.93µH, the capacitance may be 500nF, and the resonance frequency may be 85kHz.

As described above, due to the inductance tolerance of the coil 313, the resonance frequency of the transmission circuit (or resonance circuit) included in the electronic device 301 may be changed. Further, in the first graph 410, the second graph 420, and the third graph 430, the power values of ping signals having a specific frequency (e.g., 127.7kHz) may differ from each other. Therefore, even when the same voltage or current is applied to the inverter 318 for outputting a ping signal, due to the inductance tolerance of the coil 313, the power of the ping signal may differ from the intended magnitude.

Previously, due to component tolerance of an electronic device, the resonance frequency of the transmission circuit or resonance circuit included in the electronic device could be changed. Accordingly, even when a ping phase stage is started according to the same setting value, the power of the ping signal output by the electronic device could vary according to component tolerance. In other words, in the existing electronic device, the current setting value for determining the presence or absence of metal foreign objects could vary due to component tolerance, which could reduce the detection capability of metal foreign objects.

The electronic device 301 of the disclosure may maintain the power of the ping signal as before even when the resonance frequency of the transmission circuit or resonance circuit is changed due to component tolerance of the electronic device 301. Accordingly, the electronic device 301 may set a current value for determining the presence or absence of metal foreign objects without considering component tolerance, thereby increasing the detection capability of metal foreign objects. Further, through the above-described method, the electronic device may secure a stable wireless charging recognition distance.

At least some of the operations of the electronic device 301 described below may be controlled or performed by the control circuit 320. However, for convenience of explanation, the subject of the operations will be assumed to be the electronic device 301 and is described.

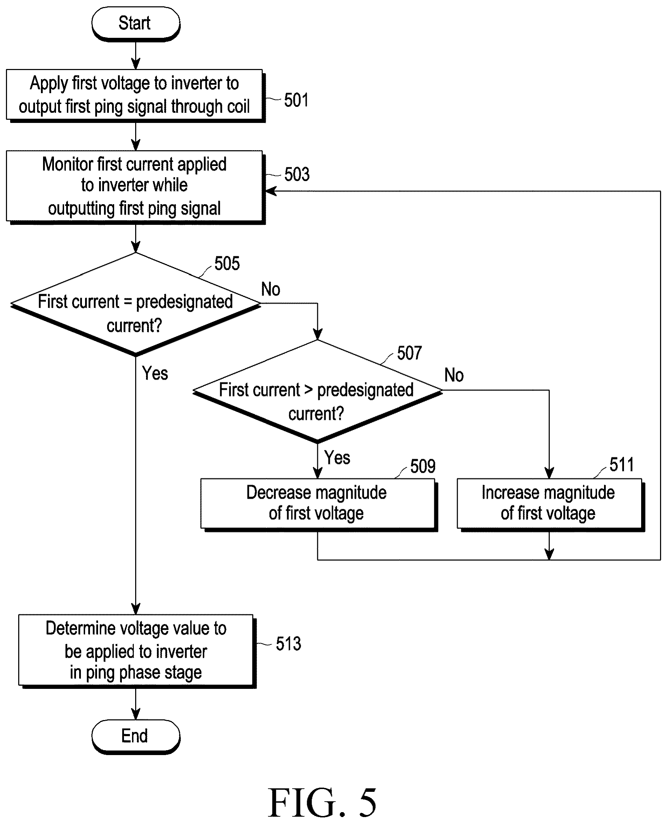

FIG. 5 is a flowchart illustrating a method by which an electronic device determines a voltage applied to an inverter to output a ping signal according to an embodiment.

Referring to FIG. 5, according to an embodiment, in operation 501, an electronic device (e.g., the electronic device 301 of FIG. 3) may apply a first voltage to an inverter (e.g., the inverter 318 of FIG. 3) to output a first ping signal through a coil (e.g., the coil 313 of FIG. 3). For example, the first voltage may be a drain voltage of each of a plurality of switches included in the inverter. The electronic device 301 may apply the first voltage to the inverter 318 to output the first ping signal in a state in which the wireless power reception device 195 is not close to the electronic device 301 or is not mounted on the electronic device 301. Alternatively, the electronic device 301 may apply the first voltage to the inverter 318 to output the first ping signal in an assembly process mode of the electronic device 301.

According to an embodiment, in operation 503, the electronic device 301 may monitor a first current applied to the inverter 318 while outputting the first ping signal. For example, the electronic device 301 may monitor the first current by determining through a current conducted to a current detection resistor included in the inverter 318.

According to an embodiment, in operation 505, the electronic device 301 may identify whether the first current matches a predesignated current based on the monitoring result.

According to an embodiment, if it is identified that the first current does not match the predesignated current (No in operation 505), in operation 507, the electronic device 301 may identify whether the first current is greater than the predesignated current.

According to an embodiment, if it is identified that the first current is greater than the predesignated current (Yes in operation 507), in operation 509, the electronic device 301 may decrease the magnitude of the first voltage applied to the inverter 318. For example, the electronic device 301 may sequentially decrease the first voltage by a designated magnitude (e.g., 50mV) unit until the first current matches the predesignated current. For example, the electronic device 301 may identify whether the first current matches the predesignated current while decreasing the voltage by a designated magnitude (e.g., 50mV) each time. For example, the electronic device 301 may decrease the voltage by a designated magnitude (e.g., 50mV) one or more times until the first current matches the predesignated current. For example, the designated magnitude for sequentially decreasing the first voltage may be set automatically or may be set by a user. For example, the electronic device 301 may apply a second voltage having a smaller magnitude than the first voltage to the inverter 318 so that the first current matches the predesignated current. For example, the second voltage may refer to a voltage applied to the inverter 318 when the first current matches the predesignated current.

According to an embodiment, if it is identified that the first current is not greater than the predesignated current (No in operation 507), in operation 511, the electronic device 301 may increase the magnitude of the first voltage applied to the inverter 318. For example, the electronic device 301 may sequentially increase the first voltage by a designated magnitude (e.g., 50mV) unit until the first current matches the predesignated current. For example, the electronic device 301 may identify whether the first current matches the predesignated current while increasing the voltage by a designated magnitude (e.g., 50mV) each time. For example, the electronic device 301 may increase the voltage by a designated magnitude (e.g., 50mV) one or more times until the first current matches the predesignated current. For example, the designated magnitude for sequentially increasing the first voltage may be set automatically or may be set by a user. For example, the electronic device 301 may apply a third voltage having a greater magnitude than the first voltage to the inverter 318 so that the first current matches the predesignated current. For example, the third voltage may refer to a voltage applied to the inverter 318 when the first current matches the predesignated current.

According to an embodiment, in operation 513, the electronic device 301 may determine a voltage value to be applied to the inverter 318 in a ping phase stage. For example, the electronic device 301 may determine the second voltage or the third voltage as the voltage value to be applied to the inverter 318 in the ping phase stage. Alternatively, the electronic device 301 may determine the first voltage as the voltage value to be applied to the inverter 318 in the ping phase stage when the first current matches the predesignated current. The electronic device 301 may store the determined voltage value as a setting value for outputting a ping signal in the ping phase stage. Thereafter, the electronic device 301 may apply a voltage having the identified voltage value to the inverter 318 to output a ping signal to identify whether the wireless power reception device 195 approaches the electronic device 301 or is mounted on the electronic device 301. For example, the electronic device 301 may apply a voltage having the determined voltage value to the inverter 318 at a designated period to output a ping signal.

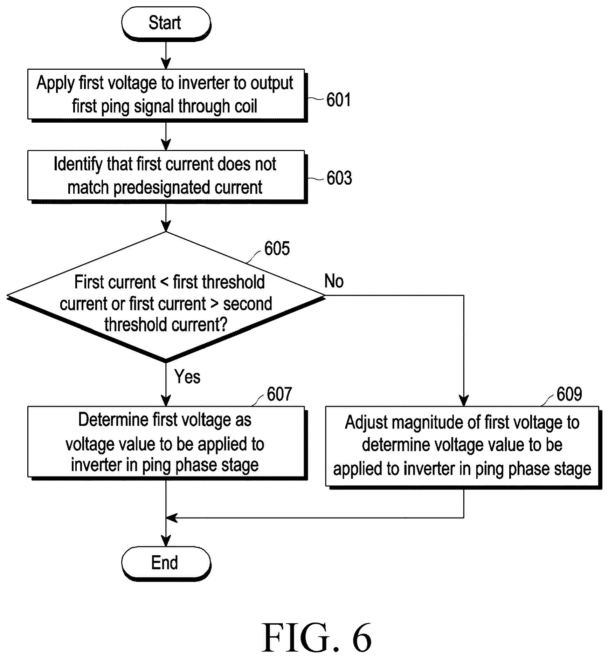

FIG. 6 is a flowchart illustrating a method by which an electronic device determines a voltage applied to an inverter to output a ping signal according to an embodiment.

Referring to FIG. 6, according to an embodiment, in operation 601, an electronic device (e.g., the electronic device 301 of FIG. 3) may apply a first voltage to an inverter (e.g., the inverter 318 of FIG. 3) to output a first ping signal through a coil (e.g., the coil 313 of FIG. 3). For example, the electronic device 301 may apply the first voltage to the inverter 318 to output the first ping signal in a state in which the wireless power reception device 195 is not close to the electronic device 301 or is not mounted on the electronic device 301. Alternatively, the electronic device 301 may apply the first voltage to the inverter 318 to output the first ping signal in an assembly process mode of the electronic device 301.

According to an embodiment, in operation 603, the electronic device 301 may monitor a first current applied to the inverter 318 while outputting the first ping signal, and may identify that the first current does not match a predesignated current based on the monitoring result.

According to an embodiment, in operation 605, the electronic device 301 may identify whether the first current is less than a first threshold current that is less than the predesignated current or the first current is greater than a second threshold current that is greater than the predesignated current. For example, the first threshold current and the second threshold current may be preset. For example, the first threshold current and the second threshold current may refer to a minimum value and a maximum value in a range in which the magnitude of the first voltage may be changed, considering product defects or the presence of metal foreign objects in an environment where calibration is performed. For example, the first threshold current and the second threshold current may be changed according to the magnitude of the predesignated current. For example, when the predesignated current is 110mA, the first threshold current may be 99mA and the second threshold current may be 121mA.

According to an embodiment, if it is identified that the first current is less than the first threshold current that is less than the predesignated current or the first current is greater than the second threshold current that is greater than the predesignated current, in operation 607, the electronic device 301 may identify the first voltage as a voltage value to be applied to the inverter 318 in a ping phase stage. For example, if it is identified that the magnitude of the first current is outside the range between the first threshold current and the second threshold current, the electronic device 201 may identify the initially set first voltage as the voltage value to be applied to the inverter 318 in the ping phase stage.

According to an embodiment, if it is identified that the first current is less than the first threshold current that is less than the predesignated current or the first current is greater than the second threshold current that is greater than the predesignated current, in operation 609, the electronic device 301 may adjust the magnitude of the first voltage to identify a voltage value to be applied to the inverter 318 in a ping phase stage. For example, if the magnitude of the first current is identified to be within the range between the first threshold current and the second threshold current, the electronic device 201 may adjust the initially set first voltage to identify the voltage value to be applied to the inverter 318 in the ping phase stage. For example, operation 609 may be performed according to the method described in operations 507 to 511 of FIG. 5 described above.

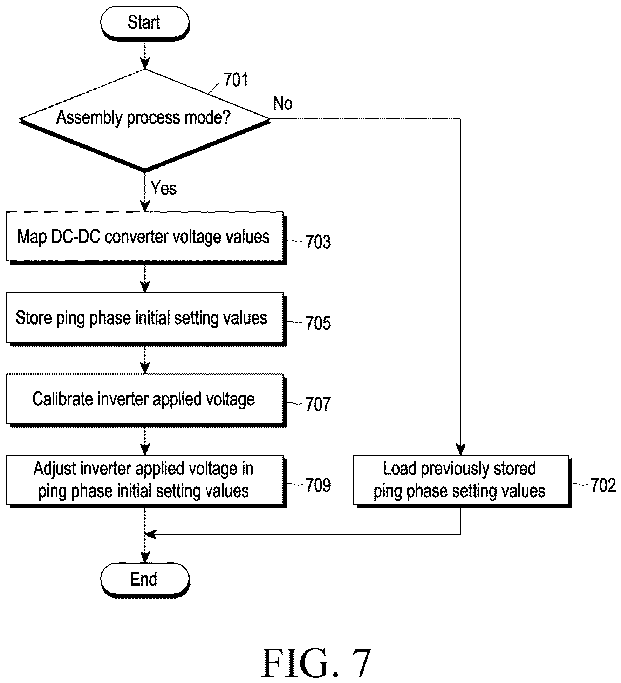

FIG. 7 is a flowchart illustrating a method by which an electronic device determines a voltage applied to an inverter to output a ping signal in a process mode according to an embodiment.

Referring to FIG. 7, according to an embodiment, in operation 701, an electronic device (e.g., the electronic device 301 of FIG. 3) may identify whether it has entered an assembly process mode. For example, the electronic device 301 may enter the assembly process mode by toggling a specific GPIO.

According to an embodiment, if it is identified that the electronic device 301 has not entered the assembly process mode (No in operation 701), in operation 702, the electronic device 301 may load a previously stored setting value for a ping phase stage. Thereafter, the electronic device 301 may output a ping signal based on the previously stored setting value (e.g., voltage value applied to the inverter 318) without calibration.

According to an embodiment, if it is identified that the electronic device 301 has entered the assembly process mode (Yes in operation 701), in operation 703, the electronic device 301 may perform an operation of mapping voltage values of a DC-DC converter (e.g., the DC-DC converter 315 of FIG. 3). For example, the electronic device 301 may obtain or sweep a control signal (e.g., I2C or PWM) capable of changing the output of the DC-DC converter (e.g., buck booster converter) 315 to measure the voltage value of the actual output voltage of the DC-DC converter (e.g., buck booster converter) 315, and may map the measured voltage value of the output voltage and the corresponding control signal. Further, the electronic device 301 may store the mapped voltage value of the output voltage.

According to an embodiment, in operation 705, the electronic device 301 may determine and store an initial setting value of a ping phase stage based on the mapped voltage value. For example, the initial setting value may include a frequency of a ping signal, a voltage value applied to the inverter 318, a predesignated current (or predesignated current value), and/or a period of a ping signal (or output period of a ping signal).

According to an embodiment, in operation 707, the electronic device 301 may perform a calibration operation for the voltage value applied to the inverter 318 included in the initial setting value. For example, the calibration operation may be performed according to the method described in connection to FIG. 5.

According to an embodiment, in operation 709, the electronic device 301 may adjust a voltage (or voltage value) applied to the inverter 318 in the ping phase initial setting value based on performing the calibration operation. Further, the electronic device 301 may store the adjusted voltage (or voltage value) as a setting value for outputting a ping signal in the ping phase stage. Thereafter, the electronic device 301 may exit the assembly process mode. Thereafter, the electronic device 301 may apply a voltage having the adjusted voltage value to the inverter 318 to output a ping signal to identify whether the wireless power reception device 195 approaches the electronic device 301 or is mounted on the electronic device 301.

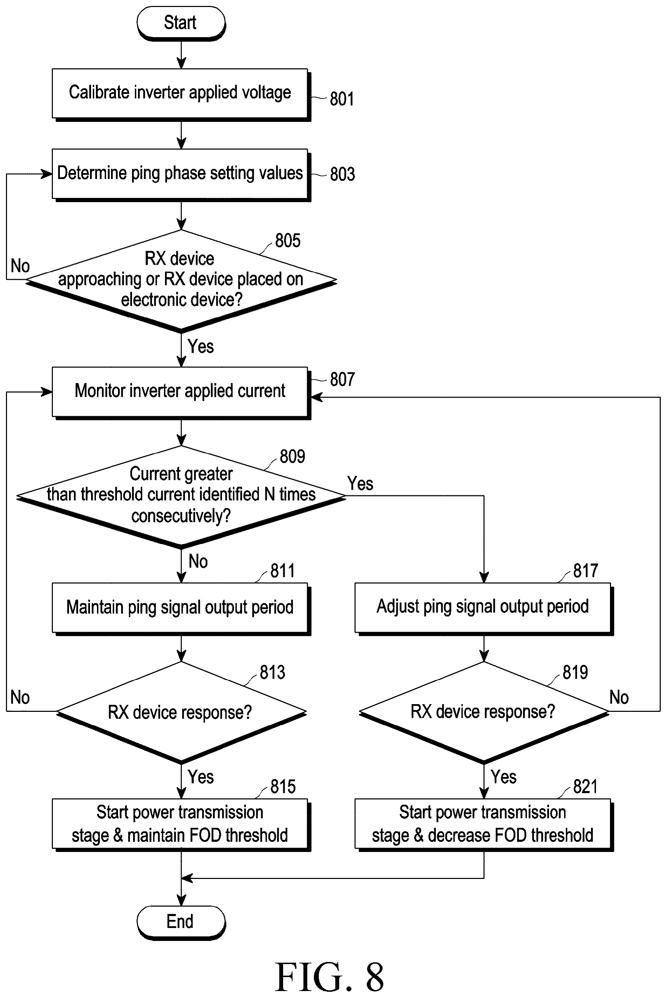

FIG. 8 is a flowchart illustrating a method by which an electronic device adjusts setting values in a ping phase stage according to an embodiment.

Referring to FIG. 8, according to an embodiment, in operation 801, an electronic device (e.g., the electronic device 301 of FIG. 3) may perform a calibration operation for a voltage applied to an inverter (e.g., the inverter 318 of FIG. 3). For example, the calibration operation may be performed according to the method described in connection to FIG. 5.

According to an embodiment, in operation 803, the electronic device 301 may determine and store a setting value of a ping phase stage based on the calibration operation.

According to an embodiment, in operation 805, the electronic device 301 may identify whether a wireless power reception device (e.g., the wireless power reception device 195 of FIG. 1) (hereinafter, RX device) approaches the electronic device 301 or is mounted on the electronic device 301. For example, after entering the ping phase stage, the electronic device 301 may output a ping signal to identify whether it approaches the electronic device 301 or is mounted on the electronic device 301. Alternatively, the electronic device 301 may also identify a capacitance change due to the approach or mounting of the RX device 195 using a separate conductive pattern disposed in an area where a coil (e.g., the coil 313 of FIG. 3) is positioned. According to implementation, operations 803 and 805 may not be temporally continuous.

According to an embodiment, in operation 807, the electronic device 301 may monitor a current applied to the inverter 318 while outputting a ping signal.

According to an embodiment, in operation 809, the electronic device 301 may identify whether a current greater than a threshold current is continuously identified N times according to the monitoring result. For example, N may be a natural number and may be automatically determined by a control circuit (e.g., the control circuit 320 of FIG. 3) or may be determined by a user. The threshold current may be a current value serving as a reference for adjusting an output period of a ping signal or adjusting an FOD threshold. For example, the threshold current may be automatically determined by a control circuit (e.g., the control circuit 320 of FIG. 3) or may be determined by a user.

According to an embodiment, when a current greater than the threshold current is not continuously identified N times (No in operation 809), in operation 811, the electronic device 301 may maintain the output period of the ping signal at the existing setting value.

According to an embodiment, in operation 813, the electronic device 301 may identify whether there is a response from the RX device 195. For example, the electronic device 301 may identify whether a response signal or a response packet (e.g., signal strength packet (SSP)) is received. When a response signal or a response packet is not received (No in operation 813), the electronic device 301 may continue to monitor the current applied to the inverter 318.

According to an embodiment, if a response signal or a response packet is received (Yes in operation 813), in operation 815, the electronic device 301 may start or enter a power transmission stage. Further, the electronic device 301 may maintain a threshold (e.g., threshold power value) for foreign object detection (FOD) at the existing setting value.

According to an embodiment, if a current greater than the threshold current is continuously identified N times (Yes in operation 809), in operation 817, the electronic device 301 may adjust the output period of the ping signal. For example, the electronic device 301 may increase the output period of the ping signal based on the existing setting value.

According to an embodiment, in operation 819, the electronic device 301 may identify whether there is a response from the RX device 195. For example, the electronic device 301 may identify whether a response signal or a response packet (e.g., signal strength packet (SSP)) is received. When a response signal or a response packet is not received (No in operation 819), the electronic device 301 may continue to monitor the current applied to the inverter 318.

According to an embodiment, if a response signal or a response packet is received (Yes in operation 819), in operation 821, the electronic device 301 may start or enter a power transmission stage. Further, the electronic device 301 may decrease a threshold (e.g., threshold power value) for foreign object detection (FOD) from the existing setting value.

Through the above-described method, the electronic device 301 may maintain the power of the ping signal as before even when the resonance frequency of the transmission circuit or resonance circuit is changed due to component tolerance of the electronic device 301. Accordingly, the electronic device 301 may set a current value for determining the presence or absence of metal foreign objects without considering component tolerance, thereby increasing the detection capability of metal foreign objects. Further, through the above-described method, the electronic device may secure a stable wireless charging recognition distance.

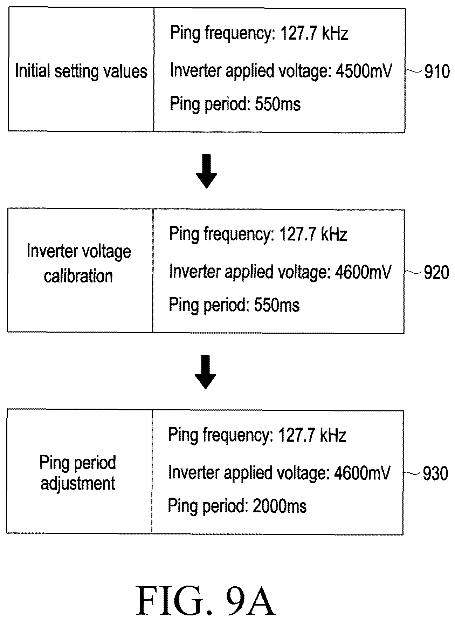

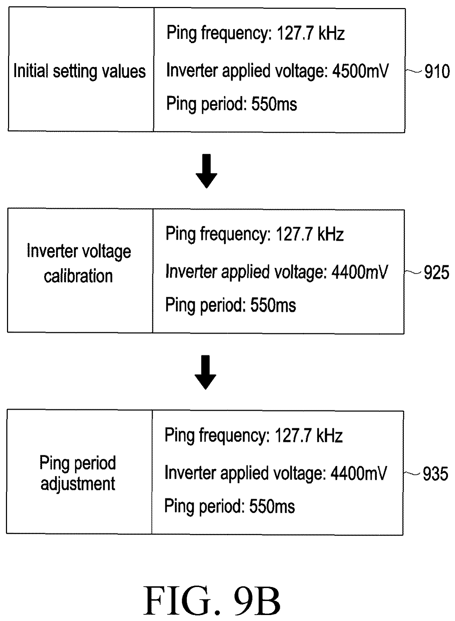

FIGS. 9A and 9B are views illustrating setting values adjusted by an electronic device according to an embodiment.

Referring to FIGS. 9A and 9B, according to an embodiment, the electronic device 301 may identify an initial setting value 910 for a ping phase stage. For example, the initial setting value 910 may have a ping frequency of 127.7kHz, an inverter applied voltage of 4500mV, and a ping period of 550ms. The predesignated current may be 110mA. In this case, the inverter applied voltage may be determined based on a resonance circuit where the inductance of the coil is 6.3µH and the resonance frequency is 90kHz.

Referring to FIG. 9A, according to an embodiment, an electronic device (e.g., the electronic device 301 of FIG. 3) may identify a current applied to the inverter 318. For example, if the current applied to the inverter 318 is identified to be 100mA, the electronic device 301 may increase the inverter applied voltage so that the current increases to 110mA. For example, when the inverter applied current becomes 1 10mA, the inverter applied voltage may be 4600mV.

According to an embodiment, the electronic device 301 may determine and store a calibrated setting value 920 through calibration of the inverter voltage. For example, the calibrated setting value 920 may have a ping frequency of 127.7kHz, an inverter applied voltage of 4600mV, and a ping period of 550ms. In this case, the inverter applied voltage may be based on a resonance circuit where the inductance of the coil is 6.93µH and the resonance frequency is 85kHz. For example, the inductance of the coil may be 10% greater than the intended inductance.

According to an embodiment, the electronic device 301 may output a ping signal based on the calibrated setting value 920 in the ping phase stage. The electronic device 301 may identify a current applied to the inverter 318 in the ping phase stage. For example, if it is identified that the current applied to the inverter 318 is greater than 160mA corresponding to the threshold current N times continuously, the electronic device 301 may increase the ping period (or output period of the ping signal). For example, the electronic device 301 may increase the ping period to 2000ms.

Referring to FIG. 9B, according to an embodiment, the electronic device 301 may identify a current applied to the inverter 318. For example, if the current applied to the inverter 318 is identified to be 120mA, the electronic device 301 may decrease the inverter applied voltage so that the current decreases to 110mA. For example, when the inverter applied current becomes 110mA, the inverter applied voltage may be 4400mV.

According to an embodiment, the electronic device 301 may determine and store a calibrated setting value 925 through calibration of the inverter voltage. For example, the calibrated setting value 925 may have a ping frequency of 127.7kHz, an inverter applied voltage of 4400mV, and a ping period of 550ms. In this case, the inverter applied voltage may be based on a resonance circuit where the inductance of the coil is 5.67µH and the resonance frequency is 95kHz. For example, the inductance of the coil may be 10% less than the intended inductance.

According to an embodiment, the electronic device 301 may output a ping signal based on the calibrated setting value 925 in the ping phase stage. The electronic device 301 may identify a current applied to the inverter 318 in the ping phase stage. For example, when it is not identified that the current applied to the inverter 318 is greater than 160mA corresponding to the threshold current N times continuously, the electronic device 301 may maintain the ping period (or output period of the ping signal). For example, the electronic device 301 may maintain the ping period at 550ms.

According to the above-described method, the electronic device 301 may adjust the setting values of the ping phase stage. Accordingly, the electronic device 301 may enhance the detection capability of metal foreign objects.

The above-described electronic device 301 may be implemented to be identical or similar to the electronic device 1001 of FIG. 10 described below.

FIG. 10 is a view illustrating an electronic device in a network environment according to various embodiments.

FIG. 10 is a block diagram illustrating an electronic device 1001 in a network environment 1000 according to various embodiments. Referring to FIG. 10, the electronic device 1001 in the network environment 1000 may communicate with at least one of an electronic device 1002 via a first network 1098 (e.g., a short-range wireless communication network), or an electronic device 1004 or a server 1008 via a second network 1099 (e.g., a long-range wireless communication network). According to an embodiment, the electronic device 1001 may communicate with the electronic device 1004 via the server 1008. According to an embodiment, the electronic device 1001 may include a processor 1020, memory 1030, an input module 1050, a sound output module 1055, a display module 1060, an audio module 1070, a sensor module 1076, an interface 1077, a connecting terminal 1078, a haptic module 1079, a camera module 1080, a power management module 1088, a battery 1089, a communication module 1090, a subscriber identification module (SIM) 1096, or an antenna module 1097. In an embodiment, at least one (e.g., the connecting terminal 1078) of the components may be omitted from the electronic device 1001, or one or more other components may be added in the electronic device 1001. According to an embodiment, some (e.g., the sensor module 1076, the camera module 1080, or the antenna module 1097) of the components may be integrated into a single component (e.g., the display module 1060).

The processor 1020 may execute, for example, software (e.g., the program 1040) to control at least one other component (e.g., a hardware or software component) of the electronic device 1001 coupled with the processor 1020, and may perform various data processing or computation. According to an embodiment, as at least part of the data processing or computation, the processor 1020 may store a command or data received from another component (e.g., the sensor module 1076 or the communication module 1090) in volatile memory 1032, process the command or the data stored in the volatile memory 1032, and store resulting data in non-volatile memory 1034. According to an embodiment, the processor 1020 may include a main processor 1021 (e.g., a central processing unit (CPU) or an application processor (AP)), or an auxiliary processor 1023 (e.g., a graphics processing unit (GPU), a neural processing unit (NPU), an image signal processor (ISP), a sensor hub processor, or a communication processor (CP)) that is operable independently from, or in conjunction with, the main processor 1021. For example, when the electronic device 1001 includes the main processor 1021 and the auxiliary processor 1023, the auxiliary processor 1023 may be configured to use lower power than the main processor 1021 or to be specified for a designated function. The auxiliary processor 1023 may be implemented as separate from, or as part of the main processor 1021.

The auxiliary processor 1023 may control at least some of functions or states related to at least one component (e.g., the display module 1060, the sensor module 1076, or the communication module 1090) among the components of the electronic device 1001, instead of the main processor 1021 while the main processor 1021 is in an inactive (e.g., sleep) state, or together with the main processor 1021 while the main processor 1021 is in an active state (e.g., executing an application). According to an embodiment, the auxiliary processor 1023 (e.g., an image signal processor or a communication processor) may be implemented as part of another component (e.g., the camera module 1080 or the communication module 1090) functionally related to the auxiliary processor 1023. According to an embodiment, the auxiliary processor 1023 (e.g., the neural processing unit) may include a hardware structure specified for artificial intelligence model processing. The artificial intelligence model may be generated via machine learning. Such learning may be performed, e.g., by the electronic device 1001 where the artificial intelligence is performed or via a separate server (e.g., the server 1008). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1030 may store various data used by at least one component (e.g., the processor 1020 or the sensor module 1076) of the electronic device 1001. The various data may include, for example, software (e.g., the program 1040) and input data or output data for a command related thereto. The memory 1030 may include the volatile memory 1032 or the non-volatile memory 1034.

The program 1040 may be stored in the memory 1030 as software, and may include, for example, an operating system (OS) 1042, middleware 1044, or an application 1046.

The input module 1050 may receive a command or data to be used by other component (e.g., the processor 1020) of the electronic device 1001, from the outside (e.g., a user) of the electronic device 1001. The input module 1050 may include, for example, a microphone, a mouse, a keyboard, keys (e.g., buttons), or a digital pen (e.g., a stylus pen).

The sound output module 1055 may output sound signals to the outside of the electronic device 1001. The sound output module 1055 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1060 may visually provide information to the outside (e.g., a user) of the electronic device 1001. The display module 1060 may include, for example, a display, a hologram device, or a projector and control circuitry to control a corresponding one of the display, hologram device, and projector. According to an embodiment, the display module 1060 may include a touch sensor configured to detect a touch, or a pressure sensor configured to measure the intensity of a force generated by the touch.

The audio module 1070 may convert a sound into an electrical signal and vice versa. According to an embodiment, the audio module 1070 may obtain the sound via the input module 1050, or output the sound via the sound output module 1055 or a headphone of an external electronic device (e.g., an electronic device 1002) directly (e.g., wiredly) or wirelessly coupled with the electronic device 1001.

The sensor module 1076 may detect an operation state (e.g., power or temperature) of the electronic device 1001 or an external environmental state (e.g., the user's state), and then generate an electrical signal or data value corresponding to the detected state. According to an embodiment, the sensor module 1076 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 1077 may support one or more specified protocols to be used for the electronic device 1001 to be coupled with the external electronic device (e.g., the electronic device 1002) directly (e.g., wiredly) or wirelessly. According to an embodiment, the interface 1077 may include, for example, a high definition multimedia interface (HDMI), a universal serial bus (USB) interface, a secure digital (SD) card interface, or an audio interface.

A connecting terminal 1078 may include a connector via which the electronic device 1001 may be physically connected with the external electronic device (e.g., the electronic device 1002). According to an embodiment, the connecting terminal 1078 may include, for example, an HDMI connector, a USB connector, an SD card connector, or an audio connector (e.g., a headphone connector).

The haptic module 1079 may convert an electrical signal into a mechanical stimulus (e.g., a vibration or motion) or electrical stimulus which may be recognized by a user via his tactile sensation or kinesthetic sensation. According to an embodiment, the haptic module 1079 may include, for example, a motor, a piezoelectric element, or an electric stimulator.

The camera module 1080 may capture a still image or moving images. According to an embodiment, the camera module 1080 may include one or more lenses, image sensors, image signal processors, or flashes.

The power management module 1088 may manage power supplied to the electronic device 1001. According to an embodiment, the power management module 1088 may be implemented as at least part of, for example, a power management integrated circuit (PMIC).

The battery 1089 may supply power to at least one component of the electronic device 1001. According to an embodiment, the battery 1089 may include, for example, a primary cell which is not rechargeable, a secondary cell which is rechargeable, or a fuel cell.

The communication module 1090 may support establishing a direct (e.g., wiredly) communication channel or a wireless communication channel between the electronic device 1001 and the external electronic device (e.g., the electronic device 1002, the electronic device 1004, or the server 1008) and performing communication via the established communication channel. The communication module 1090 may include one or more communication processors that are operable independently from the processor 1020 (e.g., the application processor (AP)) and supports a direct (e.g., wiredly) communication or a wireless communication. According to an embodiment, the communication module 1090 may include a wireless communication module 1092 (e.g., a cellular communication module, a short-range wireless communication module, or a global navigation satellite system (GNSS) communication module) or a wired communication module 1094 (e.g., a local area network (LAN) communication module or a power line communication (PLC) module). A corresponding one of these communication modules may communicate with the external electronic device 1004 via a first network 1098 (e.g., a short-range communication network, such as Bluetooth^{™}, wireless-fidelity (Wi-Fi) direct, or infrared data association (IrDA)) or a second network 1099 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 1092 may identify or authenticate the electronic device 1001 in a communication network, such as the first network 1098 or the second network 1099, using subscriber information (e.g., international mobile subscriber identity (IMSI)) stored in the subscriber identification module 1096.

The wireless communication module 1092 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1092 may support a high-frequency band (e.g., the mmWave band) to achieve, e.g., a high data transmission rate. The wireless communication module 1092 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1092 may support various requirements specified in the electronic device 1001, an external electronic device (e.g., the electronic device 1004), or a network system (e.g., the second network 1099). According to an embodiment, the wireless communication module 1092 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1097 may transmit or receive a signal or power to or from the outside (e.g., the external electronic device). According to an embodiment, the antenna module 1097 may include one antenna including a radiator formed of a conductor or conductive pattern formed on a substrate (e.g., a printed circuit board (PCB)). According to an embodiment, the antenna module 1097 may include a plurality of antennas (e.g., an antenna array). In this case, at least one antenna appropriate for a communication scheme used in a communication network, such as the first network 1098 or the second network 1099, may be selected from the plurality of antennas by, e.g., the communication module 1090. The signal or the power may then be transmitted or received between the communication module 1090 and the external electronic device via the selected at least one antenna. According to an embodiment, other parts (e.g., radio frequency integrated circuit (RFIC)) than the radiator may be further formed as part of the antenna module 1097.

According to various embodiments, the antenna module 1097 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1001 and the external electronic device 1004 via the server 1008 coupled with the second network 1099. The external electronic devices 1002 or 1004 each may be a device of the same or a different type from the electronic device 1001. According to an embodiment, all or some of operations to be executed at the electronic device 1001 may be executed at one or more of the external electronic devices 1002, 1004, or 1008. For example, if the electronic device 1001 should perform a function or a service automatically, or in response to a request from a user or another device, the electronic device 1001, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1001. The electronic device 1001 may provide the outcome, with or without further processing of the outcome, as at least part of a reply to the request. To that end, a cloud computing, distributed computing, mobile edge computing (MEC), or client-server computing technology may be used, for example. The electronic device 1001 may provide ultra low-latency services using, e.g., distributed computing or mobile edge computing. In another embodiment, the external electronic device 1004 may include an Internet-of-things (IoT) device. The server 1008 may be an intelligent server using machine learning and/or a neural network. According to an embodiment, the external electronic device 1004 or the server 1008 may be included in the second network 1099. The electronic device 1001 may be applied to intelligent services (e.g., smart home, smart city, smart car, or health-care) based on 5G communication technology or IoT-related technology.

According to an embodiment, an electronic device 301 wirelessly transmitting power may include a coil 313, an inverter 318 configured to provide power to the coil, a power providing circuit 315 configured to provide a voltage for driving the inverter, and a control circuit 320. According to an embodiment, the control circuit may be configured to apply a designated first voltage to the inverter to output a first ping signal through the coil. According to an embodiment, the control circuit may be configured to monitor a first current applied to the inverter while outputting the first ping signal. According to an embodiment, the control circuit may be configured to identify whether the first current matches a predesignated current. According to an embodiment, the control circuit may be configured to adjust the magnitude of the first voltage applied to the inverter so that the first current matches the predesignated current, based on the first current not matching the predesignated current. According to an embodiment, the control circuit may be configured to determine a voltage value to be applied to the inverter in a ping phase stage based on the adjustment of the magnitude of the first voltage.

According to an embodiment, the control circuit may be configured to sequentially decrease the first voltage by a designated magnitude until the first current matches the predesignated current when the first current is greater than the predesignated current. According to an embodiment, the control circuit may be configured to sequentially increase the first voltage by the designated magnitude until the first current matches the predesignated current when the first current is less than the predesignated current.

According to an embodiment, the control circuit may be configured to apply a second voltage having a smaller magnitude than the first voltage to the inverter so that the first current matches the predesignated current if the first current is identified to be greater than the predesignated current. According to an embodiment, the control circuit may be configured to apply a third voltage having a greater magnitude than the first voltage to the inverter so that the first current matches the predesignated current if the first current is identified to be less than the predesignated current.

According to an embodiment, the control circuit may be configured to determine the second voltage or the third voltage as the voltage value to be applied to the inverter in the ping phase stage.

According to an embodiment, the control circuit may be configured to determine the first voltage as the voltage value to be applied to the inverter in the ping phase stage when the first current matches the predesignated current.

According to an embodiment, the control circuit may be configured to determine the first voltage as the voltage value to be applied to the inverter in the ping phase stage when the first current is less than a first threshold current that is less than the predesignated current or greater than a second threshold current that is greater than the predesignated current.

According to an embodiment, the control circuit may be configured to output a ping signal by applying a voltage having the voltage value to the inverter to identify whether a wireless power reception device 195 is mounted on the electronic device.

According to an embodiment, the control circuit may be configured to monitor the magnitude of the current applied to the inverter while applying the voltage having the voltage value to the inverter. According to an embodiment, the control circuit may be configured to increase the output period of the ping signal based on the magnitude of the current being greater than a threshold current. According to an embodiment, the control circuit may be configured to maintain the output period of the ping signal based on the magnitude of the current not being greater than the threshold current.

According to an embodiment, the control circuit may be configured to start a power transmission operation if a response signal to the ping signal is received from the wireless power receiver. According to an embodiment, the control circuit may be configured to decrease a threshold power for foreign object detection (FOD) after the power transmission operation is started, based on the magnitude of the current being greater than the threshold current.

According to an embodiment, the control circuit may be configured to adjust the magnitude of the first voltage applied to the inverter so that the first current matches the predesignated current in a state in which a wireless power reception device 195 is not mounted on the electronic device.

According to an embodiment, the control circuit may be configured to adjust the magnitude of the first voltage applied to the inverter so that the first current matches the predesignated current in a process mode of the electronic device.

According to an embodiment, a method of operating an electronic device 301 wirelessly transmitting power may include applying a designated first voltage to an inverter 318 included in the electronic device to output a first ping signal through a coil 313 included in the electronic device. According to an embodiment, the method of operating the electronic device may include monitoring a first current applied to the inverter while outputting the first ping signal. According to an embodiment, the method of operating the electronic device may include determining whether the first current matches a predesignated current. According to an embodiment, the method of operating the electronic device may include adjusting the magnitude of the first voltage applied to the inverter so that the first current matches the predesignated current, based on the first current not matching the predesignated current. According to an embodiment, the method of operating the electronic device may include determining a voltage value to be applied to the inverter in a ping phase stage based on the adjustment of the magnitude of the first voltage.

According to an embodiment, the operation of adjusting the magnitude of the first voltage may include sequentially decreasing the first voltage by a designated magnitude until the first current matches the predesignated current when the first current is greater than the predesignated current. According to an embodiment, the operation of adjusting the magnitude of the first voltage may include sequentially increasing the first voltage by the designated magnitude until the first current matches the predesignated current when the first current is less than the predesignated current.

According to an embodiment, the operation of adjusting the magnitude of the first voltage may include applying a second voltage having a smaller magnitude than the first voltage to the inverter so that the first current matches the predesignated current if the first current is identified to be greater than the predesignated current. According to an embodiment, the operation of adjusting the magnitude of the first voltage may include applying a third voltage having a greater magnitude than the first voltage to the inverter so that the first current matches the predesignated current if the first current is identified to be less than the predesignated current.

According to an embodiment, the operation of determining the voltage value to be applied to the inverter may include determining the second voltage or the third voltage as the voltage value to be applied to the inverter in the ping phase stage.

According to an embodiment, the operation of determining the voltage value to be applied to the inverter may include determining the first voltage as the voltage value to be applied to the inverter in the ping phase stage when the first current matches the predesignated current.

According to an embodiment, the operation of determining the voltage value to be applied to the inverter may include determining the first voltage as the voltage value to be applied to the inverter in the ping phase stage when the first current is less than a first threshold current that is less than the predesignated current or greater than a second threshold current that is greater than the predesignated current.

According to an embodiment, the method of operating the electronic device may further include outputting a ping signal by applying a voltage having the voltage value to the inverter to identify whether a wireless power reception device 195 is mounted on the electronic device. According to an embodiment, the method of operating the electronic device may further include monitoring the magnitude of the current applied to the inverter while applying the voltage having the voltage value to the inverter. According to an embodiment, the method of operating the electronic device may further include increasing the output period of the ping signal based on the magnitude of the current being greater than a threshold current. According to an embodiment, the method of operating the electronic device may further include maintaining the output period of the ping signal based on the magnitude of the current not being greater than the threshold current.

According to an embodiment, the operation of adjusting the magnitude of the first voltage applied to the inverter may include adjusting the magnitude of the first voltage applied to the inverter so that the first current matches the predesignated current in a state in which a wireless power reception device 195 is not mounted on the electronic device.

According to an embodiment, a non-transitory recording medium 1030 may store instructions executable to perform operations including applying a designated first voltage to an inverter 318 included in an electronic device 301 wirelessly transmitting power to output a first ping signal through a coil 313 included in the electronic device, monitoring a first current applied to the inverter while outputting the first ping signal, determining whether the first current matches a predesignated current, adjusting the magnitude of the first voltage applied to the inverter so that the first current matches the predesignated current based on the first current not matching the predesignated current, and determining a voltage value to be applied to the inverter in a ping phase stage based on the adjustment of the magnitude of the first voltage.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 1040) including one or more instructions that are stored in a storage medium (e.g., internal memory 1036 or external memory 1038) that is readable by a machine (e.g., the electronic device 1001). For example, a processor (e.g., the processor 1020) of the machine (e.g., the electronic device 1001) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (301) wirelessly transmitting power, comprising:
a coil (313);
an inverter (318) configured to provide power to the coil;
a power providing circuit (315) configured to provide a voltage for driving the inverter; and
a control circuit (320), wherein the control circuit is configured to:
apply a designated first voltage to the inverter to output a first ping signal through the coil;
monitor a first current applied to the inverter while outputting the first ping signal;
identify whether the first current matches a predesignated current;
based on the first current not matching the predesignated current, adjust a magnitude of the first voltage applied to the inverter so that the first current matches the predesignated current; and
determine a voltage value to be applied to the inverter in a ping phase stage based on the adjustment of the magnitude of the first voltage.

2. The electronic device of claim 1, wherein the control circuit is configured to:
when the first current is greater than the predesignated current, sequentially decrease the first voltage by a designated magnitude until the first current matches the predesignated current; and
when the first current is less than the predesignated current, sequentially increase the first voltage by the designated magnitude until the first current matches the predesignated current.

3. The electronic device of any one of claims 1 to 2, wherein the control circuit is configured to:
if the first current is identified to be greater than the predesignated current, apply a second voltage having a smaller magnitude than the first voltage to the inverter so that the first current matches the predesignated current; and
if the first current is identified to be less than the predesignated current, apply a third voltage having a greater magnitude than the first voltage to the inverter so that the first current matches the predesignated current.

4. The electronic device of any one of claims 1 to 3, wherein the control circuit is configured to determine the second voltage or the third voltage as the voltage value to be applied to the inverter in the ping phase stage.

5. The electronic device of any one of claims 1 to 4, wherein the control circuit is configured to determine the first voltage as the voltage value to be applied to the inverter in the ping phase stage when the first current matches the predesignated current.

6. The electronic device of any one of claims 1 to 5, wherein the control circuit is configured to determine the first voltage as the voltage value to be applied to the inverter in the ping phase stage when the first current is less than a first threshold current that is less than the predesignated current or greater than a second threshold current that is greater than the predesignated current.

7. The electronic device of any one of claims 1 to 6, wherein the control circuit is configured to output a ping signal by applying a voltage having the voltage value to the inverter to identify whether a wireless power reception device (195) is mounted on the electronic device.

8. The electronic device of any one of claims 1 to 7, wherein the control circuit is configured to:
monitor a magnitude of a current applied to the inverter while applying the voltage having the voltage value to the inverter;
increase an output period of the ping signal based on the magnitude of the current being greater than a threshold current; and
maintain the output period of the ping signal based on the magnitude of the current not being greater than the threshold current.

9. The electronic device of any one of claims 1 to 8, wherein the control circuit is configured to:
start a power transmission operation if a response signal to the ping signal is received from the wireless power receiver; and
decrease a threshold power for foreign object detection (FOD) after the power transmission operation is started, based on the magnitude of the current being greater than the threshold current.

10. The electronic device of any one of claims 1 to 9, wherein the control circuit is configured to adjust the magnitude of the first voltage applied to the inverter so that the first current matches the predesignated current in a state in which a wireless power reception device (195) is not mounted on the electronic device.

11. The electronic device of any one of claims 1 to 10, wherein the control circuit is configured to adjust the magnitude of the first voltage applied to the inverter so that the first current matches the predesignated current in a process mode of the electronic device.

12. A method of operating an electronic device (301) wirelessly transmitting power, comprising:
applying a designated first voltage to an inverter (318) included in the electronic device to output a first ping signal through a coil (313) included in the electronic device;
monitoring a first current applied to the inverter while outputting the first ping signal;
determining whether the first current matches a predesignated current;
based on the first current not matching the predesignated current, adjusting a magnitude of the first voltage applied to the inverter so that the first current matches the predesignated current; and
determining a voltage value to be applied to the inverter in a ping phase stage based on the adjustment of the magnitude of the first voltage.

13. The method of claim 12, wherein adjusting the magnitude of the first voltage includes:
when the first current is greater than the predesignated current, sequentially decreasing the first voltage by a designated magnitude until the first current matches the predesignated current; and
when the first current is less than the predesignated current, sequentially increasing the first voltage by the designated magnitude until the first current matches the predesignated current.

14. The method of any one of claims 12 to 13, wherein adjusting the magnitude of the first voltage includes:
if the first current is identified to be greater than the predesignated current, applying a second voltage having a smaller magnitude than the first voltage to the inverter so that the first current matches the predesignated current; and
if the first current is identified to be less than the predesignated current, applying a third voltage having a greater magnitude than the first voltage to the inverter so that the first current matches the predesignated current.

15. The method of any one of claims 12 to 14, wherein determining the voltage value to be applied to the inverter includes determining the second voltage or the third voltage as the voltage value to be applied to the inverter in the ping phase stage.
